# EUROPEAN PATENT APPLICATION

(11) **EP 4 818 596 A1**
(43) Date of publication of application: **07.10.2026**
(21) Application number: 24909856.7
(22) Date of filing: 16.08.2024
(51) Int. Cl.: F25B 5/04

(54) **ENERGY STORAGE DEVICE AND PHOTOVOLTAIC ENERGY STORAGE SYSTEM**

(30) Priority: 29.12.2023 CN 202311868179
(71) Applicant: Huawei Digital Power Technologies Co., Ltd., Shenzhen, Guangdong 518043 (CN)
(72) Inventor: ZHANG, Hongji, Shenzhen, Guangdong 518043 (CN); LI, Malin, Shenzhen, Guangdong 518043 (CN); LIU, Naitong, Shenzhen, Guangdong 518043 (CN); KONG, Li, Shenzhen, Guangdong 518043 (CN)
(74) Representative: Maiwald GmbH
(86) International application number: PCT/CN2024/112863
(87) International publication number: WO 2025/138905

(57) **Abstract**

An energy storage device (1000) and a photovoltaic energy storage system are disclosed. A heat management system (400) of the energy storage device (1000) includes a compressor (410), a condenser (420), an expansion valve (430), a dehumidification module (450), and a first evaporator (440), and the dehumidification module (450) includes a second evaporator (4501). A refrigerant outlet (4102) of the compressor (410) is connected to a refrigerant inlet (4201) of the condenser (420), and a refrigerant outlet (4202) of the condenser (420) is connected to a refrigerant inlet (4301) of the expansion valve (430). A refrigerant outlet (4302) of the expansion valve (430) is connected to a refrigerant inlet (45011) of the second evaporator (4501), a refrigerant outlet (45012) of the second evaporator (4501) is connected to a refrigerant inlet (4401) of the first evaporator (440), and a refrigerant outlet (4402) of the first evaporator (440) is connected to a refrigerant inlet (4101) of the compressor (410).

## Description

### CROSS-REFERENCE TO RELATED APPLICATIONS

This application claims priority to Chinese Patent Application No. 202311868179.8, filed with the China National Intellectual Property Administration on December 29, 2023 and entitled "ENERGY STORAGE DEVICE AND PHOTOVOLTAIC ENERGY STORAGE SYSTEM", which is incorporated herein by reference in its entirety.

### TECHNICAL FIELD

This application relates to the field of energy technologies, and in particular, to an energy storage device and a photovoltaic energy storage system.

### BACKGROUND

With continuous development of clean energy, energy storage devices for storing electric energy begin to be widely used in a plurality of fields. Currently, there are an increasing quantity of large cabinet-level or container-level energy storage devices, to improve an electric energy storage capability of the energy storage device by configuring more batteries.

A heat management system is usually configured in the energy storage device to perform heat management on loads such as a battery and a power module in the device, so that temperatures of the battery, the power module, and the like can keep within an appropriate temperature range, to ensure normal running of the energy storage device. In addition, a dehumidification module can be further integrated in the heat management system, to reduce humidity inside the energy storage device, thereby reducing a risk of corrosion to the loads in the energy storage device. Generally, the dehumidification module is connected to an outlet of a compressor. However, due to limited mounting space of the heat management system in the energy storage device, a size of the dehumidification module cannot be designed to be excessively large. This is likely to cause a case in which the compressor lacks suction superheat, impacting the compressor by a liquid refrigerant, and even causing damage to the compressor.

### SUMMARY

This application provides an energy storage device and a photovoltaic energy storage system, to increase suction superheat of a compressor, thereby ensuring safe running of the compressor and improving running reliability of the energy storage device.

According to a first aspect, this application provides an energy storage device. The energy storage device includes a heat management system. The heat management system includes a compressor, a condenser, an expansion valve, a dehumidification module, and a first evaporator. The dehumidification module includes a second evaporator. A refrigerant outlet of the compressor is connected to a refrigerant inlet of the condenser, and a refrigerant outlet of the condenser is connected to a refrigerant inlet of the expansion valve. A refrigerant outlet of the expansion valve is connected to a refrigerant inlet of the second evaporator, a refrigerant outlet of the second evaporator is connected to a refrigerant inlet of the first evaporator, and a refrigerant outlet of the first evaporator is connected to a refrigerant inlet of the compressor. In the heat management system of the energy storage device provided in this application, the first evaporator and the second evaporator of the dehumidification module are connected in series in a same refrigerant circulation loop, and the first evaporator is located on the refrigerant outlet side of the second evaporator. In this way, the first evaporator may heat a refrigerant flowing out of the refrigerant outlet of the second evaporator, so that the refrigerant flowing to the refrigerant inlet of the compressor is heated. This helps increase suction superheat of the compressor, to reduce a risk of impacting the compressor by the liquid refrigerant, thereby improving running safety of the compressor and improving running reliability of the energy storage device. In addition, the heat management system of the energy storage device is designed according to the solution provided in this application, allowing to select an expansion valve with a large diameter while ensuring the suction superheat of the compressor. In this way, a possibility that the expansion valve becomes dirty and blocked can be effectively reduced, and a requirement of the heat management system for refrigerant cleanness may be reduced, thereby improving running reliability of the heat management system and reducing costs of the heat management system. In addition, in comparison with a solution in which a first evaporator and a second evaporator are connected in parallel in an existing heat management system, in the heat management system of the energy storage device provided in this application, at least one expansion valve and one temperature sensor can be saved. This helps reduce costs of the heat management system.

In a possible implementation of this application, the dehumidification module further includes a first fan. An air exhaust vent of the first fan is provided toward the second evaporator. The first fan is configured to blow air in the energy storage device to the second evaporator, to accelerate a circulation speed of air flowing through the second evaporator, thereby reducing a temperature of the second evaporator. This helps improve dehumidification effect of the dehumidification module.

In a possible implementation of this application, the heat management system further includes a bypass valve. A refrigerant inlet of the bypass valve is connected to the refrigerant inlet of the second evaporator, and a refrigerant outlet of the bypass valve is connected to the refrigerant outlet of the second evaporator. In this case, the bypass valve is disposed in parallel with the second evaporator. In this way, when the energy storage device does not require dehumidification, the bypass valve may be opened to bypass the second evaporator, so that the refrigerant flowing through the first evaporator has a small pressure drop and a small flow resistance. This helps increase a heat exchange capacity of the first evaporator, thereby improving energy efficiency of the heat management system.

In a possible implementation of this application, the heat management system further includes a four-way valve. The refrigerant inlet of the first evaporator is connected to a first valve port of the four-way valve, the refrigerant outlet of the second evaporator is connected to a second valve port of the four-way valve, the refrigerant inlet of the second evaporator is connected to a third valve port of the four-way valve, and the refrigerant outlet of the expansion valve is connected to a fourth valve port of the four-way valve. In this way, when the first valve port of the four-way valve is connected to the second valve port of the four-way valve, and the third valve port of the four-way valve is connected to the fourth valve port of the four-way valve, the first evaporator and the second evaporator can be connected in series, thereby implementing a dehumidification function of the dehumidification module. In addition, when the energy storage device does not require dehumidification, the first valve port of the four-way valve is connected to the fourth valve port of the four-way valve, and the second valve port of the four-way valve is connected to the third valve port of the four-way valve. In this case, the second evaporator is bypassed, and the refrigerant enters the compressor through the first evaporator. In this case, the refrigerant flowing through the first evaporator has a smaller pressure drop and a smaller flow resistance. This helps increase the heat exchange capacity of the first evaporator, thereby improving energy efficiency of the heat management system.

In a possible implementation of this application, the energy storage device further includes a battery module, a power module, and a radiator. The battery module includes a battery and a battery heat exchange plate. The battery is in contact with the battery heat exchange plate. The power module includes a power circuit and a power circuit heat exchange plate. In addition, the heat management system further includes a multi-way valve. A coolant outlet of the first evaporator is connected to a first valve port of the multi-way valve, and a coolant inlet of the first evaporator is connected to a second valve port of the multi-way valve. A coolant outlet of the battery heat exchange plate is connected to a third valve port of the multi-way valve, and a coolant inlet of the battery heat exchange plate is connected to a fourth valve port of the multi-way valve. A coolant outlet of the power circuit board is connected to a fifth valve port of the multi-way valve, a coolant inlet of the power circuit board is connected to a coolant outlet of the condenser, and a coolant inlet of the condenser is connected to a sixth valve port of the multi-way valve. A coolant outlet of the radiator is connected to a seventh valve port of the multi-way valve, and a coolant inlet of the radiator is connected to an eighth valve port of the multi-way valve. In this way, connection statuses between valve ports of the multi-way valve may be controlled, to implement different connection manners between coolant paths, so that a plurality of different coolant circulation loops are formed between the coolant paths, thereby providing a feasibility condition for implementing a plurality of working modes for the heat management system.

In a possible implementation of this application, the heat management system further includes an electric heater. A coolant inlet of the electric heater is connected to the fourth valve port of the multi-way valve, and a coolant outlet of the electric heater is connected to the coolant inlet of the battery heat exchange plate. In this way, in a low-temperature scenario, the electric heater may be configured to heat a coolant entering the battery heat exchange plate, to transfer heat to the battery by using the battery heat exchange plate, to heat the battery.

In a possible implementation of this application, the heat management system further includes a first pump and a second pump. A coolant outlet of the first pump is connected to the coolant inlet of the first evaporator, and a coolant inlet of the first pump is connected to the second valve port of the multi-way valve. Alternatively, a coolant inlet of the first pump is connected to the coolant outlet of the first evaporator, and a coolant outlet of the first pump is connected to the first valve port of the multi-way valve. A coolant outlet of the second pump is connected to the coolant inlet of the condenser, and a coolant inlet of the second pump is connected to the sixth valve port of the multi-way valve. Alternatively, a coolant inlet of the second pump is connected to the coolant outlet of the condenser, and a coolant outlet of the second pump is connected to the coolant inlet of the power circuit heat exchange plate. In this way, the first pump may be disposed in one coolant path of the heat management system, and the second pump may be disposed in another coolant path of the heat management system. In addition, each coolant circulation loop that may be formed in the heat management system may include at least one of the first pump and the second pump, to drive circulation of the coolant in each coolant circulation loop.

In a possible implementation of this application, the heat management system further includes a liquid refill kettle. The liquid refill kettle may fill liquid for at least one coolant circulation loop in the heat management system. This helps meet amount requirements of the heat management system for coolants in different working modes, thereby ensuring that a coolant in each coolant circulation loop is always at a better flow rate, and improving running reliability and running stability of the heat management system.

In addition, when the coolant outlet of the second pump is connected to the coolant inlet of the condenser, and the coolant inlet of the second pump is connected to the sixth valve port of the multi-way valve, the liquid refill kettle is disposed between the second pump and the sixth valve port of the multi-way valve. Alternatively, when the coolant inlet of the second pump is connected to the coolant outlet of the condenser, and the coolant outlet of the second pump is connected to the coolant inlet of the power circuit heat exchange plate, the liquid refill kettle is disposed between the power circuit heat exchange plate and the fifth valve port of the multi-way valve. In this way, the liquid refill kettle may be used to accommodate a coolant that is in excess after heat expansion in the coolant circulation loop of the heat management system, to reduce a risk of rupture of a connection pipeline in the coolant circulation loop due to excessive pressure.

In a possible implementation of this application, the first evaporator is a plate heat exchanger. The second evaporator is a microchannel heat exchanger or a finned tube heat exchanger. In this way, heat exchange effect of the first evaporator can be ensured, and the first evaporator can effectively heat the refrigerant flowing out of the refrigerant outlet of the second evaporator, to increase the suction superheat of the compressor.

According to a second aspect, this application further provides a photovoltaic energy storage system. The photovoltaic energy storage system includes a photovoltaic power generation device, a power conversion device, and the energy storage device in the first aspect. The power device is connected between the photovoltaic power generation device and the energy storage device. The photovoltaic power generation device is configured to store generated electric energy into the energy storage device by using the power conversion device, to store the electric energy by using the energy storage device. The foregoing energy storage device is used, so that running reliability of the photovoltaic energy storage system can be effectively improved.

According to a third aspect, this application further provides a charging network that may include a charging pile and the energy storage device according to the first aspect. The charging pile is electrically connected to the energy storage device. The energy storage device is configured to supply electric energy to the charging pile. The foregoing energy storage device is used, so that running reliability of the charging network can be effectively improved.

### BRIEF DESCRIPTION OF DRAWINGS

FIG. 1 is a diagram of an application scenario of an energy storage device according to an embodiment of this application;
FIG. 2 is a diagram of another application scenario of an energy storage device according to an embodiment of this application;
FIG. 3 is a diagram of a structure of an energy storage device according to an embodiment of this application;
FIG. 4 is a diagram of a structure of a conventional energy storage device according to an embodiment of this application;
FIG. 5 is a diagram of a system structure of an energy storage device according to an embodiment of this application;
FIG. 6 is a diagram of another system structure of an energy storage device according to an embodiment of this application;
FIG. 7 is a diagram of another system structure of an energy storage device according to an embodiment of this application; and
FIG. 8 is a diagram of a system structure of the energy storage device shown in FIG. 7 in a working mode without a dehumidification requirement.

### Brief description of drawings:

1000: energy storage device; 100: cabinet body; 1001: cabinet door; 200: battery module; 210: battery; 220: battery heat exchange plate;
2201: coolant inlet of a battery heat exchange plate; 2202: coolant outlet of a battery heat exchange plate; 300: power module; 310: power circuit;
320: power circuit heat exchange plate; 3201: coolant inlet of a power circuit heat exchange plate; 3202: coolant outlet of a power circuit heat exchange plate;
400: heat management system; 410: compressor; 4101: refrigerant inlet of a compressor; 4102: refrigerant outlet of a compressor;
420: condenser; 4201: refrigerant inlet of a condenser; 4202: refrigerant outlet of a condenser; 4203: coolant inlet of a condenser;
4204: coolant outlet of a condenser; 430: expansion valve; 430a: first expansion valve; 430b: second expansion valve;
4301: refrigerant inlet of an expansion valve; 4302: refrigerant outlet of an expansion valve; 4301a: refrigerant inlet of a first expansion valve;
4301b: refrigerant inlet of a second expansion valve; 440: first evaporator; 4401: refrigerant inlet of a first evaporator;
4402: refrigerant outlet of a first evaporator; 4403: coolant inlet of a first evaporator; 4404: coolant outlet of a first evaporator;
450: dehumidification module; 4501: second evaporator; 45011: refrigerant inlet of a second evaporator;
45012: refrigerant outlet of a second evaporator; 4502: first fan; 460: multi-way valve; 470: electric heater;
4701: coolant inlet of an electric heater; 4702: coolant outlet of an electric heater; 480: first pump;
4801: coolant inlet of a first pump; 4802: coolant outlet of a first pump; 490: second pump; 4901: coolant inlet of a second pump;
4902: coolant outlet of a second pump; 4100: liquid refill kettle; 4110: bypass valve; 41101: refrigerant inlet of a bypass valve;
41102: refrigerant outlet of a bypass valve; 4120: four-way valve; 500: radiator module;
510: radiator; 5101: coolant inlet of a radiator; 5102: coolant outlet of a radiator; 520: second fan;
T1 and T2: temperature sensors;
A: first coolant path; B: second coolant path; C: third coolant path; D: fourth coolant path;
v1: first valve port of a multi-way valve; v2: second valve port of a multi-way valve; v3: third valve port of a multi-way valve; v4: fourth valve port of a multi-way valve;
v5: fifth valve port of a multi-way valve; v6: sixth valve port of a multi-way valve; v7: seventh valve port of a multi-way valve; v8: eighth valve port of a multi-way valve;
a1: first valve port of a four-way valve; a2: second valve port of a four-way valve; a3: third valve port of a four-way valve; a4: fourth valve port of a four-way valve.

### DESCRIPTION OF EMBODIMENTS

To make the objectives, technical solutions, and advantages of this application clearer, the following further describes embodiments of this application in detail with reference to the accompanying drawings. However, example implementations may be implemented in a plurality of forms, and should not be construed as being limited to implementations described herein. Identical reference numerals in the accompanying drawings denote identical or similar structures. Therefore, repeated descriptions thereof are omitted. Expressions of positions and directions in embodiments of this application are described by using the accompanying drawings as an example. However, changes may also be made as required, and all the changes fall within the protection scope of this application. The accompanying drawings in embodiments of this application are merely used to illustrate a relative position relationship and do not represent an actual scale.

It should be noted that specific details are set forth in the following description to facilitate understanding of this application. However, embodiments of this application can be implemented in a plurality of manners different from those described herein, and a person skilled in the art can perform similar promotion without departing from the connotation of embodiments of this application. Therefore, this application is not limited to the specific implementations disclosed in the following.

An energy storage device is a device that can store electric energy by using a specific medium and release the stored energy to generate electricity when required. The energy storage device may be used in five types of industrial and commercial energy storage scenarios such as small-scale commercial and industrial energy storage (such as a small factory), medium-sized commercial and industrial energy storage, large-scale commercial and industrial energy storage, photovoltaic energy storage charging station, and small- and medium-sized microgrid (such as an island), and three types of power station scenarios such as a wind/solar energy storage power station, a grid energy storage power station, and a large microgrid.

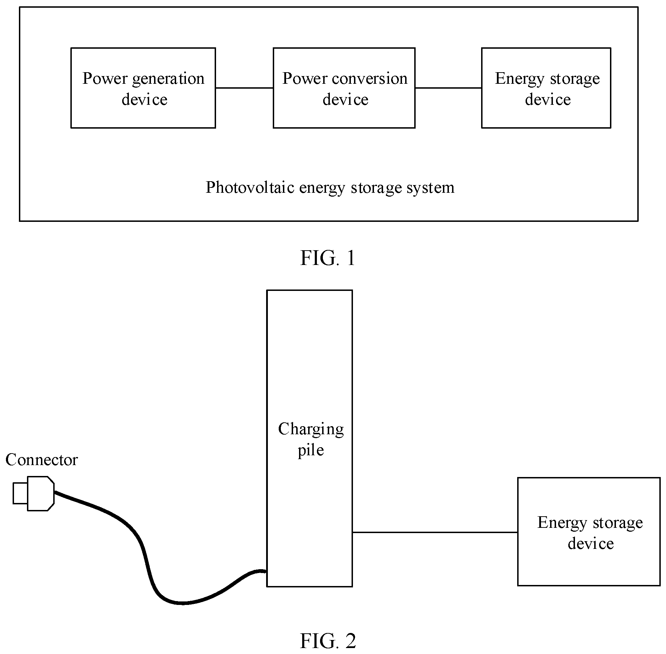

As shown in FIG. 1, FIG. 1 is a diagram of an application scenario of an energy storage device according to an embodiment of this application. The application scenario is described by using a photovoltaic energy storage system as an example. The photovoltaic energy storage system may include a power conversion device, a power generation device, and the energy storage device. The power conversion device is connected between the power generation device and the energy storage device, and the power generation device is configured to store generated electric energy into the energy storage device by using the power conversion device.

In some embodiments, the power generation device may be a photovoltaic power generation device, and the photovoltaic power generation device may be configured to convert light energy into direct current electric energy.

In some embodiments, the power generation device may be a wind power generation device, and the wind power generation device may be configured to convert wind energy into direct current electric energy.

As shown in FIG. 2, FIG. 2 is a diagram of another application scenario of an energy storage device according to an embodiment of this application. The application scenario is described by using a charging network as an example. The charging network includes a charging pile and the energy storage device. The charging pile is electrically connected to the energy storage device through a cable, and the energy storage device may supply electric energy stored in the energy storage device to the charging pile. The charging pile has a connector, and the connector may be connected to a powered device (for example, a vehicle), to charge the powered device.

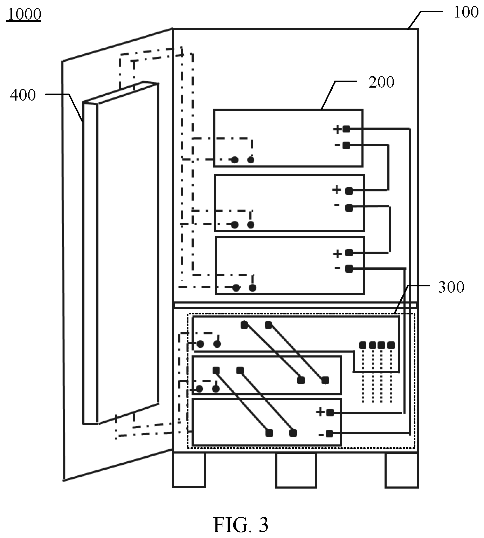

In addition, in embodiments of this application, according to different requirements of application scenarios on power consumption, energy storage devices may be classified into cabinet-level energy storage devices and container-level energy storage devices. Refer to FIG. 3. FIG. 3 is a diagram of a structure of an energy storage device 1000 according to an embodiment of this application. This embodiment is described by using a cabinet-level energy storage device as an example. The energy storage device 1000 may include a cabinet body 100, a battery module 200, and a power module 300. Both the battery module 200 and the power module 300 may be accommodated in the cabinet body 100. The battery module 200 is a basic unit for the energy storage device 1000 to store and release electric energy. The power module 300 may be configured to control a charging/discharging process of a battery. For example, the power module 300 may include a power conversion system (power conversion system, PCS) or a direct current (direct current, DC/DC) converter. The PCS may be configured to convert an alternating current into a direct current and then provide the direct current for the battery, or convert a direct current from the battery into an alternating current and then output the alternating current. The DC/DC converter may be configured to boost a voltage of the battery module 200, to ensure that a total voltage of the battery module 200 is not lower than a rated voltage, and improve running stability of the battery module 200.

In the foregoing energy storage device, the battery module 200 and the power module 300 are main heat loads in the energy storage device 1000, and temperatures of the battery module 200 and the power module 300 are important conditions for normal running of the energy storage device 1000. For the battery module 200, in an environment with a high temperature, for example, in summer or transition seasons of spring and autumn, the battery module 200 generates a large amount of heat in a charging/discharging process. In this case, the battery module 200 usually needs to be cooled, to ensure normal working of the battery module 200. However, in winter with a low temperature, the battery module 200 may encounter a charging/discharging fault due to the low temperature. Therefore, in this case, the battery module 200 needs to be heated up, to ensure normal working of the battery module 200. For the power module 300, because the power module 300 always generates a large amount of heat in a working process, the power module 300 usually needs to be cooled in time in various environmental conditions, to ensure normal running of the power module 300.

In addition, in some cases, for example, in a low-temperature and high-humidity environment, the battery module and the power module need to be dehumidified, to reduce a risk of corrosion and damage to the battery module and the power module.

Based on this, a heat management system 400 is further disposed in the current energy storage device 1000. As shown in FIG. 3, currently, to appropriately utilize space in the cabinet body 100 of the energy storage device 100, the heat management system 400 may be disposed on a cabinet door 1001 of the cabinet body 100.

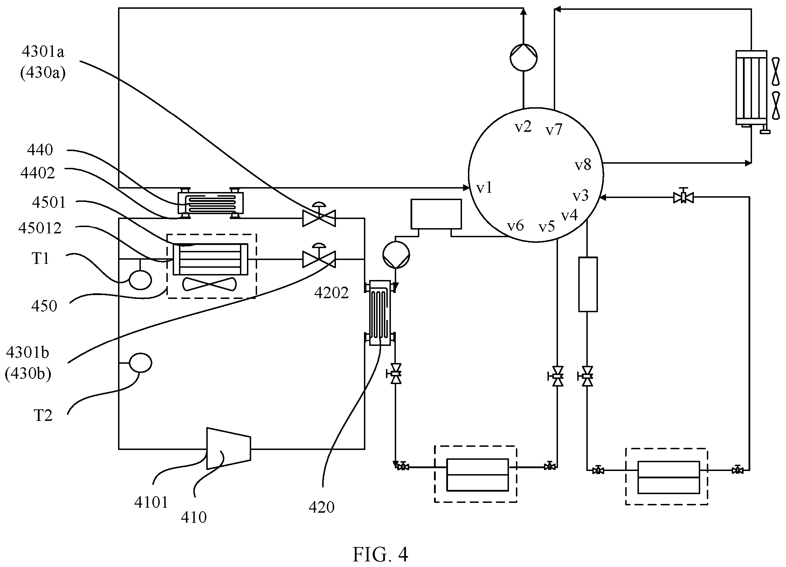

The heat management system 400 can meet temperature and humidity management requirements of both the battery module 200 and the power module 300. During specific disposition of the heat management system 400, refer to FIG. 4. FIG. 4 is a diagram of a structure of a conventional energy storage device according to an embodiment of this application. FIG. 4 shows a disposition manner of a heat management system in the energy storage device. The heat management system includes a compressor 410, a condenser 420, a first expansion valve 430a, and a first evaporator 440, and the compressor 410, the condenser 420, the first expansion valve 430a, and the first evaporator 440 are sequentially connected to form a refrigerant circulation loop.

In addition, in the energy storage device shown in FIG. 4, the heat management system further includes a dehumidification module 450 and a second expansion valve 430b. The dehumidification module 450 includes a second evaporator 4501. The second evaporator 4501 is connected in series to the second expansion valve 430b, both a refrigerant outlet 45012 of the second evaporator and a refrigerant outlet 4402 of the first evaporator are connected to a refrigerant inlet 4101 of the compressor, and both a refrigerant inlet 4301b of the second expansion valve and a refrigerant inlet 4301a of the first expansion valve are connected to a refrigerant outlet 4202 of the condenser. In this way, the second evaporator 4501 and the first evaporator 440 are connected in parallel.

Because space for disposing the heat management system in the energy storage device is limited, a size of the second evaporator 4501 in the dehumidification module 450 cannot be set to be excessively large. In addition, in a low-temperature and high-humidity environment, load of the heat management system is small, for example, less than 700 W. As a result, a heat exchange capacity of the second evaporator 4501 is small. This is likely to cause small suction superheat or no suction superheat of the compressor 410, impacting the compressor 410 by a liquid refrigerant, and even causing damage to the compressor 410.

In view of this, in the energy storage device provided in this embodiment of this application, a disposition position of the dehumidification module in the heat management system is adjusted, so that when the energy storage device requires dehumidification, a refrigerant flowing out of a refrigerant liquid outlet of the dehumidification module can be heated. This helps increase suction superheat of the compressor, thereby improving running safety of the compressor and improving running reliability of the energy storage device. To make the objectives, technical solutions, and advantages of this application clearer, the following further describes this application in detail with reference to the accompanying drawings and specific embodiments.

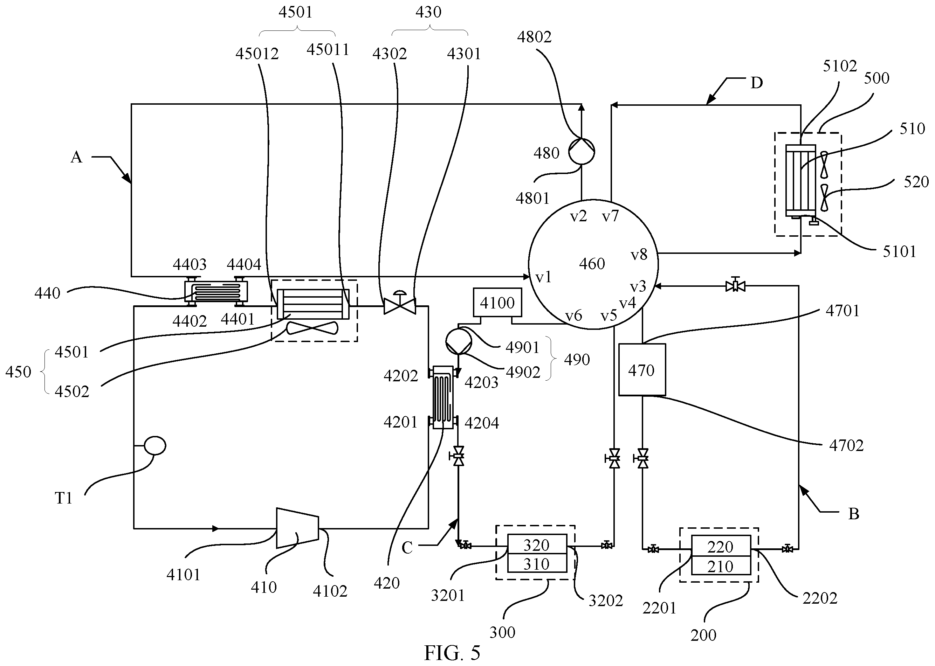

Refer to FIG. 5. FIG. 5 is a diagram of a system structure of an energy storage device according to an embodiment of this application. In the energy storage device, a heat management system includes a compressor 410, a condenser 420, an expansion valve 430, a dehumidification module 450, and a first evaporator 440. The dehumidification module 450 includes a second evaporator 4501. The second evaporator 4501 may be a microchannel heat exchanger or a finned tube heat exchanger, and the first evaporator 440 may be a plate heat exchanger.

As shown in FIG. 5, a refrigerant outlet 4102 of the compressor is connected to a refrigerant inlet 4201 of the condenser, a refrigerant outlet 4202 of the condenser is connected to a refrigerant inlet 4301 of the expansion valve, a refrigerant outlet 4302 of the expansion valve is connected to a refrigerant inlet 45011 of the second evaporator, a refrigerant outlet 45012 of the second evaporator is connected to a refrigerant inlet 4401 of the first evaporator, and a refrigerant outlet 4402 of the first evaporator is connected to a refrigerant inlet 4101 of the compressor. In this way, the compressor 410, the condenser 420, the expansion valve 430, the first evaporator 440, and the second evaporator 4501 are sequentially connected to form a refrigerant circulation loop. A refrigerant may circulate in the refrigerant circulation loop. The refrigerant may be but is not limited to freon, a liquid ammonia compound, or the like.

In this embodiment of this application, when the refrigerant flows through the second evaporator 4501, a temperature of the second evaporator 4501 is low. In this way, when humidity of air in the energy storage device is high, and the temperature of the second evaporator 4501 is lower than a dew point temperature of the air, water vapor in the air is condensed into water drops, so that the water drops are discharged through a drainpipe of the energy storage device, to reduce the humidity in the energy storage device.

It may be understood that, in a process in which the refrigerant circulates in the refrigerant circulation loop, the temperature of the second evaporator 4501 is low. Therefore, the second evaporator 4501 may further reduce a temperature of the air in the energy storage device. In addition, the dehumidification module 450 further includes a first fan 4502. An air exhaust vent of the first fan 4502 is provided toward the second evaporator 4501. The first fan 4502 is configured to blow the air in the energy storage device to the second evaporator 4501, to accelerate a circulation speed of air flowing through the second evaporator 4501, thereby reducing the temperature of the second evaporator 4501. This helps improve dehumidification effect of the dehumidification module 450.

In the heat management system of the energy storage device provided in this application, the first evaporator 440 and the second evaporator 4501 of the dehumidification module 450 are connected in series in the same refrigerant circulation loop, and the first evaporator 440 is located on the refrigerant outlet 45012 side of the second evaporator. In this way, the first evaporator 440 may heat the refrigerant flowing out of the refrigerant outlet 45012 of the second evaporator, so that the refrigerant flowing to the refrigerant inlet 4101 of the compressor is heated. This helps increase suction superheat of the compressor 410, to reduce a risk of impacting the compressor 410 by the liquid refrigerant, thereby improving running safety of the compressor 410 and improving running reliability of the energy storage device.

In addition, the heat management system of the energy storage device is designed according to the solution provided in this application, allowing to select an expansion valve 430 with a large diameter while ensuring the suction superheat of the compressor 410. In this way, a possibility that the expansion valve 430 becomes dirty and blocked can be effectively reduced, and a requirement of the heat management system for refrigerant cleanness may be reduced, thereby improving running reliability of the heat management system and reducing costs of the heat management system. In addition, in the energy storage setting provided in this application, the heat management system may include only one expansion valve 430 and one temperature sensor T1. However, the heat management system of the existing energy storage device shown in FIG. 4 includes the first expansion valve 430a, the second expansion valve 430b, a temperature sensor T1, and a temperature sensor T2. Therefore, in comparison with a solution in which the first evaporator 440 and the second evaporator 4501 are connected in parallel in the existing heat management system, in the heat management system of the energy storage device provided in this application, at least one expansion valve and one temperature sensor can be saved. This helps reduce costs of the heat management system.

In this application, a specific type of the expansion valve 430 is not limited. For example, the expansion valve 430 may be an electronic expansion valve, to improve adjustment precision of the expansion valve 430.

Still refer to FIG. 5. In the energy storage device provided in this application, the heat management system further includes a multi-way valve 460. A coolant outlet 4404 of the first evaporator is connected to a first valve port v1 of the multi-way valve, and a coolant inlet 4403 of the first evaporator is connected to a second valve port v2 of the multi-way valve, to connect a coolant runner of the first evaporator 440 to the multi-way valve 460. In this way, the first evaporator 440 and the multi-way valve 460 are connected through a coolant pipe to form a first coolant path A. In this application, the coolant path may be used for circulation of a coolant, and the coolant may be but is not limited to water, glycol, or the like.

It should be noted that, in this embodiment of this application, a coolant outlet and a coolant inlet of each component may be directly connected to the multi-way valve 460, or may be indirectly connected to the multi-way valve 460. Direct connections mean that only coolant pipes are provided between the coolant outlet and a corresponding valve port of the multi-way valve 460 and between the coolant inlet and a corresponding valve port of the multi-way valve 460. Indirect connections mean that other components are further connected in series between the coolant outlet and a corresponding valve port of the multi-way valve 460 and between the coolant inlet and a corresponding valve port of the multi-way valve 460 through coolant pipes.

The energy storage device provided in this embodiment of this application further includes a battery module 200. The battery module 200 includes a battery 210 and a battery heat exchange plate 220. The battery 210 is in contact with the battery heat exchange plate 220. A coolant outlet 2202 of the battery heat exchange plate is connected to a third valve port v3 of the multi-way valve, and a coolant inlet 2201 of the battery heat exchange plate is connected to a fourth valve port v4 of the multi-way valve. In this way, the battery heat exchange plate 220 and the multi-way valve 260 are connected through a coolant pipe to form a second coolant path B.

It should be noted that, in the energy storage device provided in this embodiment of this application, the battery heat exchange plate 220 may be a cooling plate, or may be another type of heat exchanger such as an immersion heat exchanger, provided that the battery heat exchange plate 220 can be used for circulation of the coolant and can be used to implement heat exchange with the battery 210.

As shown in FIG. 5, the energy storage device further includes a power module 300. The power module 300 includes a power circuit 310 and a power circuit heat exchange plate 320, and the power circuit 310 is in contact with the power circuit heat exchange plate 320. A coolant outlet 3202 of the power circuit heat exchange plate is connected to a fifth valve port v5 of the multi-way valve, a coolant inlet 3201 of the power circuit heat exchange plate is connected to a coolant outlet 4204 of the condenser, and a coolant inlet 4203 of the condenser is connected to a sixth valve port v6 of the multi-way valve. In this way, the condenser 420 and the power circuit heat exchange plate 320 are connected to the multi-way valve 460 through a coolant pipe, to form a third coolant path C.

It should be noted that, in the energy storage device provided in this embodiment of this application, the power circuit heat exchange plate 320 may be a cooling plate, or may be another type of heat exchanger such as an immersion heat exchanger. In addition, when both the battery heat exchange plate 220 and the power circuit heat exchange plate 320 are immersion heat exchangers, the battery heat exchange plate 220 and the power circuit heat exchange plate 320 may alternatively be disposed in an integrated manner, that is, the battery 210 and the power circuit 310 may be immersed in a same immersion heat exchanger.

Still refer to FIG. 5. The energy storage device provided in this application may further include a radiator module 500. The radiator module 500 includes a radiator 510. A coolant outlet 5102 of the radiator is connected to a seventh valve port v7 of the multi-way valve, and a coolant inlet 5101 of the radiator is connected to an eighth valve port v8 of the multi-way valve. In this way, the radiator 510 and the multi-way valve 460 are connected through a coolant pipeline to form a fourth coolant path D.

In addition, the radiator module 500 may further include a second fan 520. The second fan 520 is disposed close to the radiator 510. The second fan 520 may be configured to accelerate a circulation speed of air flowing through the radiator 510, to improving heat dissipation performance of the radiator 510.

In this application, a specific disposition form of the multi-way valve 460 is not limited. For example, the multi-way valve 460 may include an eight-way valve, to provide eight valve ports for connections of the foregoing four coolant paths by using the eight-way valve. Alternatively, the multi-way valve 460 may include two four-way valves to provide eight valve ports through a connection of the two four-way valves. Certainly, the multi-way valve 460 may alternatively be disposed in another possible manner. Disposition manners are not described herein one by one.

In the energy storage device provided in this embodiment of this application, the four coolant paths are connected through the eight valve ports of the multi-way valve 460. In this way, connection statuses between the valve ports of the multi-way valve 460 may be controlled, to implement different connection manners between the four coolant paths, so that a plurality of different coolant circulation loops are formed between the four coolant paths, thereby providing a feasibility condition for implementing a plurality of working modes for the heat management system. In addition, the multi-way valve 460 is used to establish connection relationships between the four coolant paths, so that integration of the heat management system can be improved, and a connection pipeline of the heat management system can be simplified. This helps improve energy efficiency of the heat management system.

During specific application, the connection statuses between the valve ports of the multi-way valve 460 may be controlled, so that different coolant paths are conducted to form different coolant circulation loops according to heat management requirements of the energy storage device in different scenarios. The following describes, for several possible scenarios, coolant circulation loops that can be formed by the heat management system.

In a first scenario, the first valve port v1 of the multi-way valve is connected to the fourth valve port v4 of the multi-way valve, the second valve port v2 of the multi-way valve is connected to the third valve port v3 of the multi-way valve, the fifth valve port v5 of the multi-way valve is connected to the eighth valve port v8 of the multi-way valve, and the sixth valve port v6 of the multi-way valve is connected to the seventh valve port v7 of the multi-way valve. In this scenario, the first coolant path A and the second coolant path B are connected to form a first coolant circulation loop, and the third coolant path C and the fourth coolant path D are connected to form a second coolant circulation loop. It can be seen from FIG. 5 that, the first coolant circulation loop includes the coolant runner of the first evaporator 440 and the battery heat exchange plate 220. In this scenario, heat generated by the battery 210 may be transferred to the first evaporator 440 through circulation of the coolant in the first coolant circulation loop, and the coolant cooled by the first evaporator 440 further flows to the battery heat exchange plate 220 for heat exchange. In addition, the second coolant circulation loop includes a coolant runner of the condenser 420, the power circuit heat exchange plate 320, and the radiator 510. In this way, the radiator 510 may dissipate heat for both the condenser 420 and the power circuit heat exchange plate. It can be learned that the first scenario may be a scenario in which an ambient temperature is high, such as summer. In this case, the compressor 410 needs to be turned on, and the battery 210 is cooled through circulation of the refrigerant in the refrigerant circulation loop.

In a second scenario, the first valve port v1 of the multi-way valve is connected to the fourth valve port v4 of the multi-way valve, the second valve port v2 of the multi-way valve is connected to the seventh valve port v7 of the multi-way valve, the third valve port v3 of the multi-way valve is connected to the sixth valve port v6 of the multi-way valve, and the fifth valve port v5 of the multi-way valve is connected to the eighth valve port v8 of the multi-way valve. In this scenario, the first coolant path A, the second coolant path B, the third coolant path C, and the fourth coolant path D are connected to form a third coolant circulation loop. In this case, in a process in which the coolant circulates in the third coolant circulation loop, the radiator 510 may be configured to cool the battery heat exchange plate 220 and the power circuit heat exchange plate 320, to dissipate heat for the battery 210 and the power circuit 310. It can be seen that the second scenario may be a scenario in which an ambient temperature is temperate, such as spring or autumn. In this case, the compressor 410 may be turned off, or the compressor 410 may run in a small load mode.

In a third scenario, the first valve port v1 of the multi-way valve is connected to the eighth valve port v8 of the multi-way valve, the second valve port v2 of the multi-way valve is connected to the seventh valve port v7 of the multi-way valve, the third valve port v3 of the multi-way valve is connected to the sixth valve port v6 of the multi-way valve, and the fourth valve port v4 of the multi-way valve is connected to the fifth valve port v5 of the multi-way valve. In this scenario, the first coolant path A and the fourth coolant path D are connected to form a fourth coolant circulation loop, and the second coolant path B and the third coolant path C are connected to form a fifth coolant circulation loop. It can be seen from FIG. 5 that, the fourth coolant circulation loop includes the coolant runner of the first evaporator 440 and the radiator 510. In this scenario, the coolant enters the radiator 510 after being cooled by the first evaporator 440, and the coolant is heated up in the radiator 510 through heat exchange with air on a surface of the radiator 510 and then enters the first evaporator 440 again. In addition, the fifth coolant circulation loop includes a coolant runner of the condenser 420, the battery heat exchange plate 220, and the power circuit heat exchange plate 320. In this case, after being heated up through heat exchange with the condenser 420, the coolant enters the power circuit heat exchange plate 320. Because the power circuit 310 generates a large amount of heat when working, the heat is also transferred to the coolant by using the power circuit heat exchange plate 320, to dissipate the heat of the power circuit 310. Then, the coolant enters the battery heat exchange plate 220, so that after heat exchange with the battery 210 in the battery heat exchange plate 220, the coolant cools down. Finally, the coolant returns to the coolant runner of the condenser 420, to complete one cycle. In this scenario, the power circuit 310 implement heat dissipation and cooling by transferring the heat to the coolant, and the battery 210 is heated up by absorbing heat of the coolant. Therefore, the fifth coolant circulation loop can further heat the battery to some extent by utilizing waste heat generated by the power circuit 310, so that the waste heat generated by the power circuit 310 can be appropriately utilized, and heat can be efficiently utilized.

Still refer to FIG. 5. In this embodiment of this application, the heat management system further includes an electric heater 470, and the electric heater 470 may be disposed, for example, in the second coolant path B. Specifically, a coolant inlet 4701 of the electric heater is connected to the fourth valve port v4 of the multi-way valve, and a coolant outlet 4702 of the electric heater is connected to the coolant inlet 2201 of the battery heat exchange plate. In this way, in a low-temperature scenario, the electric heater 470 may be configured to heat a coolant entering the battery heat exchange plate 220, to transfer heat to the battery 210 by using the battery heat exchange plate 220, to heat the battery 210.

It may be understood that the electric heater 470 may alternatively be disposed in another coolant path, provided that the electric heater 470 can implement a function of heating a coolant entering the battery heat exchange plate 220.

In this embodiment of this application, the heat management system may further include a first pump 480 and a second pump 490. The first pump 480 is disposed in one of the four coolant paths in the heat management system, and the second pump 490 is disposed in another coolant path of the four coolant paths in the heat management system. In addition, in the foregoing five coolant circulation loops, each coolant circulation loop includes at least one of the first pump 480 and the second pump 490, to drive circulation of the coolant in each coolant circulation loop.

Based on the foregoing considerations, in a possible embodiment, as shown in FIG. 5, the first pump 480 is disposed in the first coolant path A. In this case, the first pump 480 is connected in series to the coolant runner of the first evaporator 440. During specific implementation, a coolant outlet 4802 of the first pump is connected to the coolant inlet 4403 of the first evaporator, and a coolant inlet 4801 of the first pump is connected to the second valve port v2 of the multi-way valve. In this case, the first pump 480 is disposed between the coolant inlet 4403 of the first evaporator and the second valve port v2 of the multi-way valve. Alternatively, the first pump 480 may be disposed between the coolant outlet 4404 of the first evaporator and the first valve port v1 of the multi-way valve. Specifically, a coolant inlet 4801 of the first pump is connected to the coolant outlet 4404 of the first evaporator, and a coolant outlet 4802 of the first pump is connected to the first valve port v1 of the multi-way valve. In this way, the first pump 480 is also disposed in the first coolant circulation loop, the third coolant circulation loop, and the fourth coolant circulation loop.

Still refer to FIG. 5. The second pump 490 is disposed in the third coolant path C. In this case, the second pump 490 is connected in series to the coolant runner of the condenser 420 and the power circuit heat exchange plate 320. Specifically, a coolant outlet 4902 of the second pump is connected to the coolant inlet 4203 of the condenser, and a coolant inlet 4901 of the second pump is connected to the sixth valve port v6 of the multi-way valve. In this case, the second pump 490 is disposed between the coolant inlet 4203 of the condenser and the sixth valve port v6 of the multi-way valve. Alternatively, a coolant inlet 4901 of the second pump is connected to the coolant outlet 4204 of the condenser, and a coolant outlet 4902 of the second pump is connected to the coolant inlet 3201 of the power circuit heat exchange plate. In this case, the second pump 490 is disposed between the condenser 420 and the power circuit heat exchange plate 320. Alternatively, the second pump 490 may be disposed at another position in the third coolant path C. In this way, the second pump 490 is also disposed in the second coolant circulation loop, the third coolant circulation loop, and the fifth coolant circulation loop.

The foregoing describes only an example of disposition positions of the first pump 480 and the second pump 490 in the heat management system. In another possible embodiment of this application, specific disposition positions of the first pump 480 and the second pump 490 may alternatively be adjusted. The specific disposition positions are not described herein one by one, but should be understood as falling within the protection scope of this application.

Still refer to FIG. 5. In this embodiment of this application, the heat management system further includes a liquid refill kettle 4100. The liquid refill kettle 4100 may be connected to one of the four coolant paths. Any one of the four coolant paths is directly connected to another coolant path in a same coolant circulation loop, or indirectly communicates another coolant path through another coolant path. Therefore, the liquid refill kettle 4100 may fill liquid for any one of the five coolant circulation loops, to meet amount requirements of the heat management system for coolants in different working modes, thereby ensuring that a coolant in each coolant circulation loop is always at a better flow rate, and improving running reliability and running stability of the heat management system.

In a possible embodiment of this application, the liquid refill kettle 4100 is connected in a coolant path having a pump, and the liquid refill kettle 4100 is disposed adjacent to the pump, so that the pump can fetch liquid from the liquid refill kettle 4100 at any time. For example, in the embodiment shown in FIG. 5, when the first pump 480 is connected in the first coolant path A, and the second pump 490 is connected in the third coolant path C, the liquid refill kettle 4100 may be connected in the third coolant path C. Because the power circuit 310 generates a large amount of heat, after the power circuit heat exchange plate 320 is connected in the third coolant path C, a temperature of the coolant initially rises after the coolant flows through the power circuit heat exchange plate 320, and rises again after the coolant passes through the condenser 420. Under high temperature effect, the coolant in the third coolant path C expands to a specific extent. In this case, the liquid refill kettle 4100 is connected in the third coolant path C, so that the liquid refill kettle 4100 may be used to temporarily accommodate a coolant that is in excess after expansion, to reduce a risk of rupture of a connection pipeline in the third coolant path C due to excessive pressure.

In addition, in the third coolant path C, when the second pump 490 is connected between the coolant inlet 4203 of the condenser and the sixth valve port v6 of the multi-way valve, the liquid refill kettle 4100 may be disposed between the second pump 490 and the sixth valve port v6 of the multi-way valve, so that the liquid refill kettle 4100 is disposed closer to the sixth valve port v6 of the multi-way valve than the second pump 490; or when the second pump 490 is connected between the coolant outlet 4204 of the condenser and the fifth valve port v5 of the multi-way valve, the liquid refill kettle 4100 may be disposed closer to the fifth valve port v5 of the multi-way valve than the coolant outlet 4204 of the condenser. In this way, the liquid refill kettle 4100 can implement the foregoing liquid refill function, and can also stabilize an internal voltage of the multi-way valve 460, thereby improving working stability of the multi-way valve 460 in different connection states.

It may be understood from the foregoing descriptions of the energy storage device provided in this application that the first evaporator 440 and the dehumidification module 450 in the heat management system of the energy storage device may work independently or may work in a coupled manner, to manage a temperature and/or humidity of the energy storage device. For example, in the second scenario, that is, in a scenario in which an ambient temperature is temperate but air humidity is high, such as spring or autumn, the first fan 4502 of the dehumidification module 450 may be turned on, to implement a dehumidification function of the dehumidification module 450. In addition, the compressor 410 may run in the small load mode, and at least one of the first water pump 480 and the second water pump 490 may be turned on, so that the coolant may circulate in the third coolant circulation loop including the coolant runner of the first evaporator 440, the battery heat exchange plate 220, the coolant runner of the condenser 420, the power circuit heat exchange plate 320, and the radiator 510. In this way, the coolant may exchange heat with the battery heat exchange plate 220 and the power heat exchange plate 320, to transfer heat generated by the battery 210 and the power circuit 310 to the first evaporator 440, and exchange heat with the refrigerant flowing through the first evaporator 440. Because the first evaporator 440 is located at the refrigerant outlet 45012 of the second evaporator, the refrigerant obtained after heat exchange with the first evaporator 440 may heat the refrigerant flowing out of the refrigerant outlet 45012 of the second evaporator, to increase the suction superheat of the compressor 410 and ensure operation safety of the compressor 410.

It may be understood that, in the foregoing scenario, the first evaporator 440 is mainly used to heat the refrigerant flowing out of the refrigerant outlet 45012 of the second evaporator. In addition, when a suction superheat requirement of the compressor 410 is high, the electric heater 470 may be further turned on, to heat the coolant by using the electric heater 470, to further increase superheat of the refrigerant outlet 45012 of the second evaporator, thereby ensuring that the suction superheat of the compressor 410 meets a requirement, and enabling the compressor 410 to run safely.

In addition, in the first scenario, that is, in a scenario in which the battery 210 requires cooling, the second fan 520 of the dehumidification module 450 may be turned off, and the first water pump 480 and the second water pump 490 may be turned on, so that the coolant may circulate in the first coolant circulation loop including the coolant runner of the first evaporator 440 and the battery heat exchange plate 220. In this way, the coolant transfers heat generated by the battery 210 to the first evaporator 440, and the coolant cooled by the first evaporator 440 further flows to the battery heat exchange plate 220 for heat exchange, to cool the battery 210.

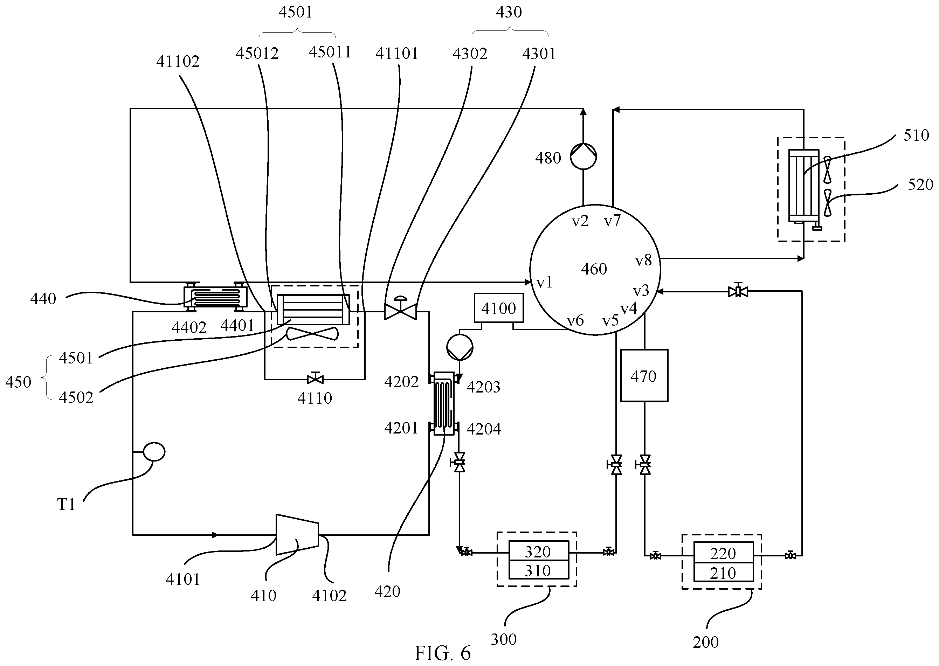

Refer to FIG. 6. FIG. 6 is a diagram of another system structure of an energy storage device according to an embodiment of this application. A difference from the energy storage device shown in FIG. 5 is that, in the energy storage device shown in FIG. 6, a heat management system further includes a bypass valve 4110. A refrigerant inlet 41101 of the bypass valve is connected to a refrigerant inlet 45011 of a second evaporator, and a refrigerant outlet 41102 of the bypass valve is connected to a refrigerant outlet 45012 of the second evaporator. In this case, the bypass valve 4110 is disposed in parallel with the second evaporator 4501. In this way, when the energy storage device does not require dehumidification, the bypass valve 4110 may be opened to bypass the second evaporator 4501, so that a refrigerant flowing through a first evaporator 440 has a small pressure drop and a small flow resistance. This helps increase a heat exchange capacity of the first evaporator 440, thereby improving energy efficiency of the heat management system.

It should be noted that, in the energy storage device shown in FIG. 6, the bypass valve 4110 may be, for example, a solenoid valve. This is not limited in this application. Another structure of the energy storage device shown in FIG. 6 may be disposed with reference to the energy storage device shown in FIG. 5. Details are not described herein again.

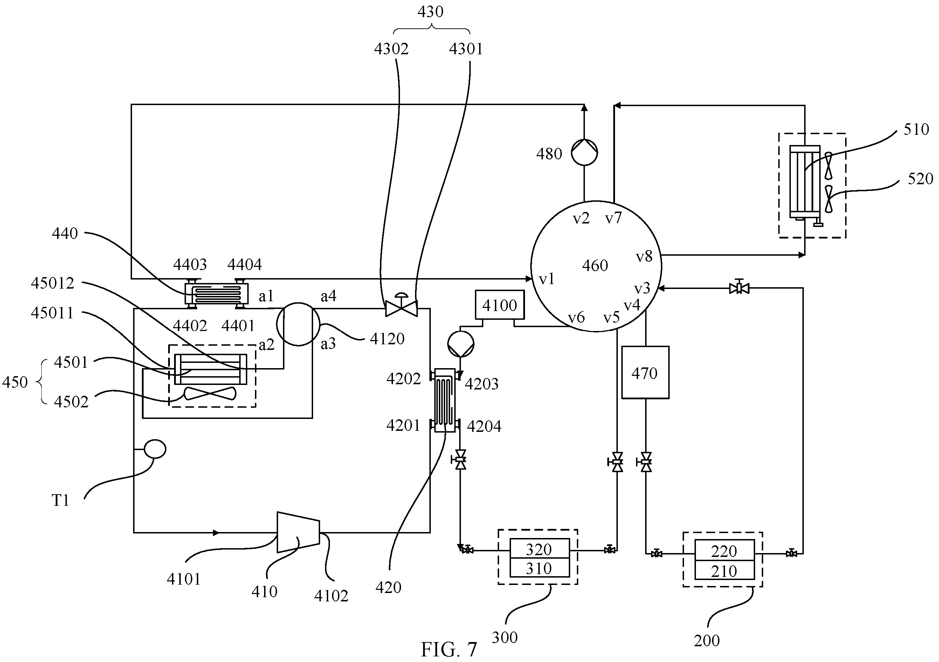

Refer to FIG. 7. FIG. 7 is a diagram of another system structure of an energy storage device according to an embodiment of this application. A difference from the energy storage device shown in FIG. 5 is that, in the energy storage device shown in FIG. 7, a heat management system further includes a four-way valve 4120. A refrigerant inlet 4401 of a first evaporator is connected to a first valve port a1 of the four-way valve, a refrigerant outlet 45012 of a second evaporator is connected to a second valve port a2 of the four-way valve, a refrigerant inlet 45011 of the second evaporator is connected to a third valve port a3 of the four-way valve, and a refrigerant outlet 4302 of an expansion valve is connected to a fourth valve port a4 of the four-way valve.

In the energy storage device shown in FIG. 7, connection statuses between valve ports of the four-way valve 4120 may be controlled, so that a connection manner between the first evaporator 440 and the second evaporator 4501 is switched. For example, refer to FIG. 7. In a second scenario, that is, in a scenario in which an ambient temperature is temperate but air humidity is high, such as spring or autumn, the first valve port a1 of the four-way valve and the second valve port a2 of the four-way valve may be controlled to be connected, and the third valve port a3 of the four-way valve and the fourth valve port a4 of the four-way valve are connected, so that the first evaporator 440 and the second evaporator 4501 are connected in series.

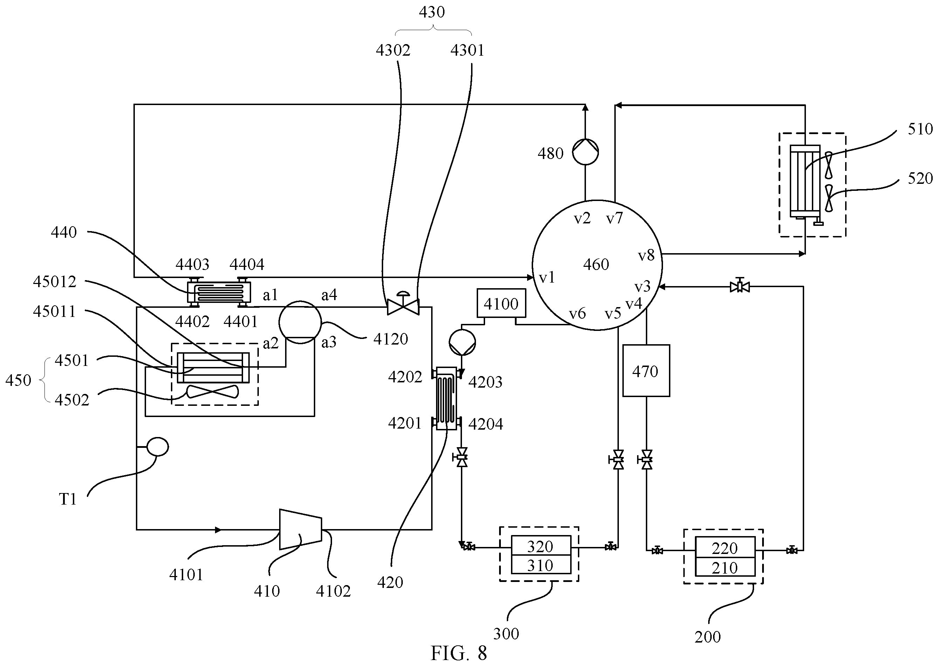

In addition, when the energy storage device does not require dehumidification, refer to FIG. 8. FIG. 8 is a diagram of a system structure of the energy storage device shown in FIG. 7 in a working mode without a dehumidification requirement. The first valve port a1 of the four-way valve is connected to the fourth valve port a4 of the four-way valve, and the second valve port a2 of the four-way valve is connected to the third valve port a3 of the four-way valve. In this case, the second evaporator 4501 is bypassed, and a refrigerant enters a compressor 410 through the first evaporator 440. In this case, the refrigerant flowing through the first evaporator 440 has a smaller pressure drop and a smaller flow resistance. This helps increase a heat exchange capacity of the first evaporator 440, thereby improving energy efficiency of the heat management system.

In conclusion, in this embodiment of this application, the first evaporator 440 and the second evaporator 4501 of a dehumidification module 450 are connected in series in a same refrigerant circulation loop, and the first evaporator 440 is located on the refrigerant outlet 45012 side of the second evaporator. In this way, the first evaporator 440 may heat the refrigerant flowing out of the refrigerant outlet 45012 of the second evaporator, so that the refrigerant flowing to a refrigerant inlet 4101 of the compressor is heated. This helps increase suction superheat of the compressor 410, to reduce a risk of impacting the compressor 410 by the liquid refrigerant, thereby improving running safety of the compressor 410 and improving running reliability of the energy storage device.

In addition, the heat management system of the energy storage device is designed according to the solution provided in this application, allowing to select an expansion valve 430 with a large diameter while ensuring the suction superheat of the compressor 410. In this way, a possibility that the expansion valve 430 becomes dirty and blocked can be effectively reduced, and a requirement of the heat management system for refrigerant cleanness may be reduced, thereby improving running reliability of the heat management system and reducing costs of the heat management system. In addition, in comparison with a solution in which the first evaporator 440 and the second evaporator 4501 are connected in parallel in the existing heat management system, in the heat management system of the energy storage device provided in this application, at least one expansion valve and one temperature sensor can be saved. This helps reduce costs of the heat management system.

It may be understood that, based on the energy storage device provided in the foregoing embodiment of this application, possible adjustment may be further made to a structure of the heat management system of the energy storage device. For example, relative positions of the first evaporator 440 and the second evaporator 4501 may be exchanged, that is, the refrigerant inlet 45011 of the second evaporator is connected to a refrigerant outlet 4402 of the first evaporator, and the refrigerant outlet 45012 of the second evaporator is connected to the refrigerant inlet 4401 of the first evaporator. In this case, a heat source may be additionally added to heat the refrigerant flowing out of the refrigerant outlet 45012 of the second evaporator, to increase the suction superheat of the compressor 410. Certainly, on this basis, another possible variation may be further made to the energy storage device provided in this embodiment of this application. Possible variations are not described herein one by one, but should be understood as falling within the protection scope of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An energy storage device, comprising a heat management system, wherein the heat management system comprises a compressor, a condenser, an expansion valve, a dehumidification module, and a first evaporator, and the dehumidification module comprises a second evaporator; and
a refrigerant outlet of the compressor is connected to a refrigerant inlet of the condenser, a refrigerant outlet of the condenser is connected to a refrigerant inlet of the expansion valve, a refrigerant outlet of the expansion valve is connected to a refrigerant inlet of the second evaporator, a refrigerant outlet of the second evaporator is connected to a refrigerant inlet of the first evaporator, and a refrigerant outlet of the first evaporator is connected to a refrigerant inlet of the compressor.

2. The energy storage device according to claim 1, wherein the dehumidification module further comprises a first fan, and an air exhaust vent of the first fan is provided toward the second evaporator.

3. The energy storage device according to claim 1 or 2, wherein the heat management system further comprises a bypass valve, a refrigerant inlet of the bypass valve is connected to the refrigerant inlet of the second evaporator, and a refrigerant outlet of the bypass valve is connected to the refrigerant outlet of the second evaporator.

4. The energy storage device according to claim 1 or 2, wherein the heat management system further comprises a four-way valve, the refrigerant inlet of the first evaporator is connected to a first valve port of the four-way valve, the refrigerant outlet of the second evaporator is connected to a second valve port of the four-way valve, the refrigerant inlet of the second evaporator is connected to a third valve port of the four-way valve, and the refrigerant outlet of the expansion valve is connected to a fourth valve port of the four-way valve.

5. The energy storage device according to any one of claims 1 to 4, wherein the energy storage device further comprises a battery module, a power module, and a radiator, the battery module comprises a battery and a battery heat exchange plate, the battery is in contact with the battery heat exchange plate, and the power module comprises a power circuit and the power circuit heat exchange plate; and
the heat management system further comprises a multi-way valve, a coolant outlet of the first evaporator is connected to a first valve port of the multi-way valve, a coolant inlet of the first evaporator is connected to a second valve port of the multi-way valve, a coolant outlet of the battery heat exchange plate is connected to a third valve port of the multi-way valve, a coolant inlet of the battery heat exchange plate is connected to a fourth valve port of the multi-way valve, a coolant outlet of the power circuit board is connected to a fifth valve port of the multi-way valve, a coolant inlet of the power circuit board is connected to a coolant outlet of the condenser, a coolant inlet of the condenser is connected to a sixth valve port of the multi-way valve, a coolant outlet of the radiator is connected to a seventh valve port of the multi-way valve, and a coolant inlet of the radiator is connected to an eighth valve port of the multi-way valve.

6. The energy storage device according to claim 5, wherein the heat management system further comprises an electric heater, a coolant inlet of the electric heater is connected to the fourth valve port of the multi-way valve, and a coolant outlet of the electric heater is connected to the coolant inlet of the battery heat exchange plate.

7. The energy storage device according to claim 5 or 6, wherein the heat management system further comprises a first pump and a second pump, and a coolant outlet of the first pump is connected to the coolant inlet of the first evaporator, and a coolant inlet of the first pump is connected to the second valve port of the multi-way valve; or a coolant inlet of the first pump is connected to the coolant outlet of the first evaporator, and a coolant outlet of the first pump is connected to the first valve port of the multi-way valve; and
a coolant outlet of the second pump is connected to the coolant inlet of the condenser, and a coolant inlet of the second pump is connected to the sixth valve port of the multi-way valve; or a coolant inlet of the second pump is connected to the coolant outlet of the condenser, and a coolant outlet of the second pump is connected to the coolant inlet of the power circuit heat exchange plate.

8. The energy storage device according to claim 7, wherein the heat management system further comprises a liquid refill kettle, and when the coolant outlet of the second pump is connected to the coolant inlet of the condenser, and the coolant inlet of the second pump is connected to the sixth valve port of the multi-way valve, the liquid refill kettle is disposed between the second pump and the sixth valve port of the multi-way valve; or
when the coolant inlet of the second pump is connected to the coolant outlet of the condenser, and the coolant outlet of the second pump is connected to the coolant inlet of the power circuit heat exchange plate, the liquid refill kettle is disposed between the power circuit heat exchange plate and the fifth valve port of the multi-way valve.

9. The energy storage device according to any one of claims 1 to 8, wherein the first evaporator is a plate heat exchanger, and the second evaporator is a microchannel heat exchanger or a finned tube heat exchanger.

10. A photovoltaic energy storage system, comprising a power generation device, a power conversion device, and the energy storage device according to any one of claims 1 to 9, wherein the power conversion device is connected between the power generation device and the energy storage device, and the power generation device is configured to store generated electric energy into the energy storage device by using the power conversion device.

11. A charging network, comprising a charging pile and the energy storage device according to any one of claims 1 to 9, wherein the charging pile is electrically connected to the energy storage device, and the energy storage device is configured to supply electric energy to the charging pile.
